# EUROPEAN PATENT SPECIFICATION

(11) **EP 1 685 272 B1**
(45) Date of publication and mention of the grant of the patent: **26.11.2008**
(21) Application number: 04782141.8
(22) Date of filing: 25.08.2004
(51) Int. Cl.: C23C 16/34, C23C 16/455

(54) **THERMAL CVD APPARATUS**
THERMISCHE CVD-VORRICHTUNG
APPAREILLAGE DE DEPOSITION THERMIQUE EN PHASE VAPEUR

(30) Priority: 25.11.2003 US 525241 P; 04.08.2004 US 911208
(43) Date of publication of application: 02.08.2006
(60) Divisional application: 07003193.5
(73) Proprietor: APPLIED MATERIALS, INC., Santa Clara, California 95054 (US)
(72) Inventor: IYER, R. Suryanarayanan, Santa Clara, CA 95054 (US); SEUTTER, Sean M., San Jose, CA 95133 (US); SMITH, Jacob W., Santa Clara, CA 95051 (US); DIBELLO, Gregory W., Mahopac, NY 10541 (US); TAM, Alexander, Union City, CA 94587 (US); TRAN, Binh, San Jose, CA 95123 (US); TANDON, Sanjeev, Sunnyvale, CA 94087 (US)
(74) Representative: Bayliss, Geoffrey Cyril
(86) International application number: PCT/US2004/027584
(87) International publication number: WO 2005/059200

(56) References cited:
- EP-A- 0 835 950
- US-A1- 2003 010 451
- US-A1- 2003 132 319
- US-A1- 2003 136 520
- US-A1- 2003 172 872
- US-B1- 6 245 192
- US-B1- 6 379 466

## Description

This invention generally relates to substrate processing and more particularly, the invention relates to a chemical vapor deposition chamber.

Thermal chemical vapor deposited (CVD) films are used to form layers of materials within integrated circuits. Thermal CVD films are used as insulators, diffusion sources, diffusion and implantation masks, spaders, and final passivation layers. The films are often deposited in chambers that are designed with specific heat and mass transfer properties to optimize the deposition of a physically and chemically uniform film across the surface of a multiple circuit carrier such as a substrate. The chambers are often part of a larger integrated tool to manufacture multiple components on the substrate surface. The chambers are designed to process one substrate at a time or to process multiple substrates.

As device geometries shrink to enable faster integrated circuits, it is desirable to reduce thermal budgets of deposited films while satisfying increasing demands for high productivity, novel film properties, and low foreign matter. Historically, thermal CVD was performed at temperatures of 700°C or higher in a batch furnace where deposition occurs in low pressure conditions over a period of a few hours. Lower thermal budget can be achieved by lowering deposition temperature that requires the use of low temperature precursors or reducing deposition time. Thermal CVD processes are sensitive to temperature variations if operating under reaction rate control or to flow non-uniformities if operating under mass transport control, or both if operating under a mix of reaction rate and mass transfer control. Effective chamber designs require precise control of temperature variations and adequately distributed flow to encourage deposition of uniform films on the substrate. Processing chamber and exhaust hardware design are inspected based on properties of precursors and reaction by-products.

US-6245192 discloses an apparatus for depositing a film on a semiconductor substrate, comprising a gas distribution chamber having a support plate, baffle plates and a shower head. The support plate comprises a support ring attached to a temperature-controlled element. The shower head is fastened to the support plate and through the support plate to the support ring. During processing, the support plate and the support ring draw heat from the shower head through the baffle assembly to control the heat distribution and temperature.

EP-A-0835950 discloses a reactant gas ejector head which enables a process gas mixture of a uniform concentration and composition to be delivered to the surface of a substrate in a stable and uniform thermodynamic state by preventing premature reactions to occur along the gas delivery route. The reactant gas ejector head comprises an injection head body having a back plate and a nozzle plate for defining a gas mixing space therebetween. The nozzle plate has numerous gas ejection nozzles. Gas distribution passages are formed between the back plate and the nozzle plate to guide at least two types of gaseous substances from the gas supply pipe separately towards peripheral I regions of the gas mixing space.

US-A-2003/0172872 discloses an apparatus for cyclical depositing of thin films on semiconductor substrates comprising a process chamber having a gas distribution system with separate paths for process gases and an exhaust system synchroriised with operation of valves dosing the process gases into a reaction region of the chamber.

US-A-2003/0136520 discloses a substrate support assembly for supporting a substrate during processing. In one arrangement a support assembly includes a ceramic body having an embedded heating element and base plate. The base plate and the ceramic body define a channel therebetween adapted to supply purge gas to a perimeter of a substrate disposed on the support assembly. The base plate is fastened to the body by brazing, adhering, fastening, press fitting or by mating engaging portions of a retention device such as a bayonet fitting.

US-A-2003/0132319 discloses a shower head assembly for distributing gases within a processing chamber. In one embodiment the shower head assembly includes a cylindrical member having a face plate coupled thereto. The cylindrical member has an outwardly extending first flange at a first end. The face plate is coupled to a second end of the cylindrical member and has a plurality of holes formed through a centre region of the face plate. The joint between the cylindrical member and the face plate allow for relative movement when subjected to thermal stresses.

US-A-2003/0010451 discloses a lid assembly for a semiconductor processing system. The lid assembly generally includes a lid having a gas manifolds mounted on a first side and a baffle plate mounted on a second side. The gas manifold is configured to deliver a plurality of gases to a plenum defined between the baffle plate and the lid. The gases are mixed within a recess formed in the baffle plate before exiting into the processing system through a single passage.

US-A-2003/0124818 discloses an apparatus for depositing a silicon film on a semiconductor comprising a processing chamber, a chamber lid, a blocker plate, a face plate and a heating element. A process gas mix comprising BTBAS is further mixed and heated in the space defined by the blocker plate and the face plate.

The present invention is directed to a CVD chamber that provides uniform heat distribution, uniform distribution of process chemicals, efficient precursor delivery, and efficient residue and exhaust management by changing the mechanical design of a single wafer thermal CVD chamber.

This invention provides a CVD apparatus for low temperature deposition of a film on a semiconductor substrate, comprising a chamber body and a chamber lid defining a processing region, a substrate support disposed in the processing region, a gas delivery system mounted on the chamber lid, the gas delivery system including blocker and face plates that define a gas mixing region, and a heating element, wherein the gas delivery system includes two spaced blocker plates and an adapter ring defining the gas mixing region, the heating element being positioned to heat the adapter ring, a face plate fastened to the adapter ring and thermal break elements located between the adapter ring and the chamber lid.

In a preferred arrangement one of the blocker plates is fastened to the chamber lid and the other blocker plate is fastened to the adapter ring.

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a cross sectional view of an embodiment of a CVD processing chamber including a gas distribution assembly and a substrate support assembly to which the present invention is applicable.

Figure 2 is an exploded view of the processing chamber and various components of the process kit.

Figure 3 is an illustration of the face plate gas inlet.

Figure 4 is a three dimensional view of a slit valve liner.

Figure 5 ls a three dimensional view of the exhaust pumping plate.

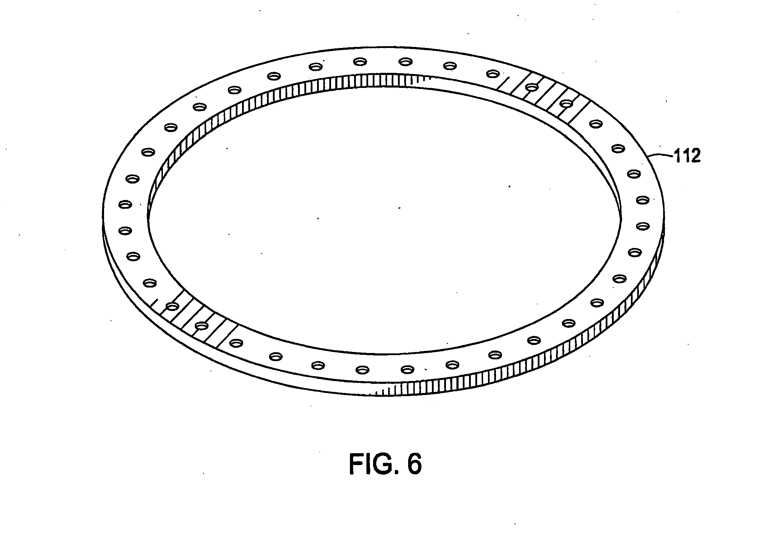

Figure 6 is a three dimensional view of a cover for the exhaust pumping plate.
Figure 7 is a three dimensional schematic drawing of a process kit for a single wafer thermal CVD process chamber and a liquid delivery system for process gas delivery to a chamber in accordance with the present invention;

Figure 8 is an illustration of the surface of the substrate showing where samples were collected across the surface of the substrate.

Embodiments of the invention provide an apparatus for depositing a layer on a substrate. The hardware discussion including illustrative figures of an embodiment is presented first. An explanation of process modifications and test results follows the hardware discussion.

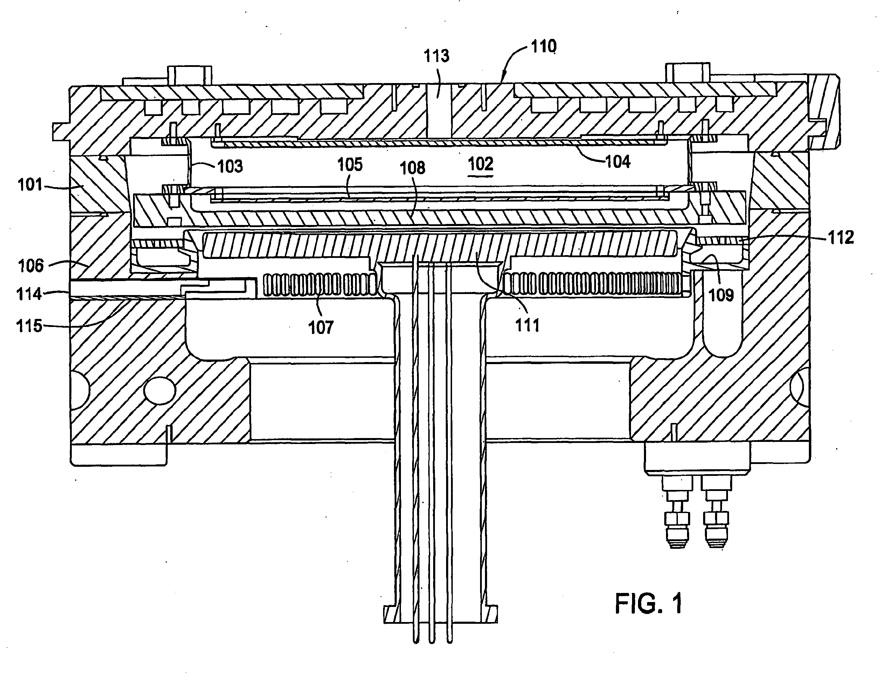

Figure 1 is a cross sectional view of a single wafer CVD processing chamber having walls 106 and a lid 110. The walls of the chamber are substantially cylindrical. Sections of the wall may be heated. A slit valve opening 114 is positioned in the wall for entry of a wafer or other substrate.

A substrate support 111 supports the substrate and may provide heat to the chamber. In addition to the substrate support, the base of the chamber may contain a substrate support assembly, a reflector plate or other mechanism tailored to facilitate heat transfer, probes to measure chamber conditions, an exhaust assembly, and other equipment to support the substrate and to control the chamber environment.

Feed gas may enter the chamber through a gas delivery system after passing through a mixer 113 in the lid 110 and holes (not shown) in a first blocker plate 104. The feed gas is gaseous which may include vapors of liquids and gases. The gas then travels through a mixing region 102 created between a first blocker plate 104 and a second blocker plate 105. The second blocker plate 105 is structurally supported by an adapter ring 103. After the gas passes through holes (not shown) in the second blocker plate 105, the gas flows through a face plate 108 and then enters the main processing region defined by the chamber walls 106, the face plate 108, and the substrate support 111. The gas then exits the chamber through the exhaust plate 109. The lid 110 may further include gas feed inlets, a gas mixer, a plasma source, and one or more gas distribution assemblies. Optionally, the chamber may include an insert piece 101 between the chamber walls 106 and the lid 110 that is heated to provide heat to the adaptor ring 103 to heat the mixing region 102 and the face plate 108. Another hardware option illustrated by Figure 1 is the exhaust plate cover 112, which rests on top of the exhaust pumping plate 109. Finally, a slit valve liner 115 may be used optionally to reduce heat loss through the slit valve opening 114.

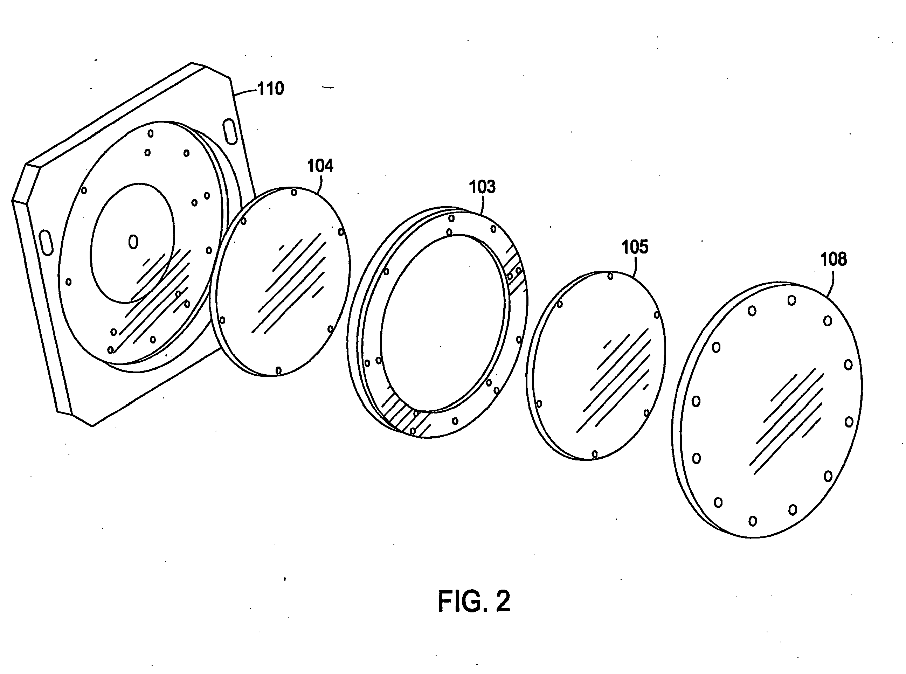

Figure 2 is an exploded view of the gas feed system. Figure 2 illustrates how the lid 110, plurality of blocker plates 104,105, the adaptor ring 103, and the face plate 108 may be configured to provide a space with heated surfaces for heating and mixing the gases before they enter the processing region of the chamber.

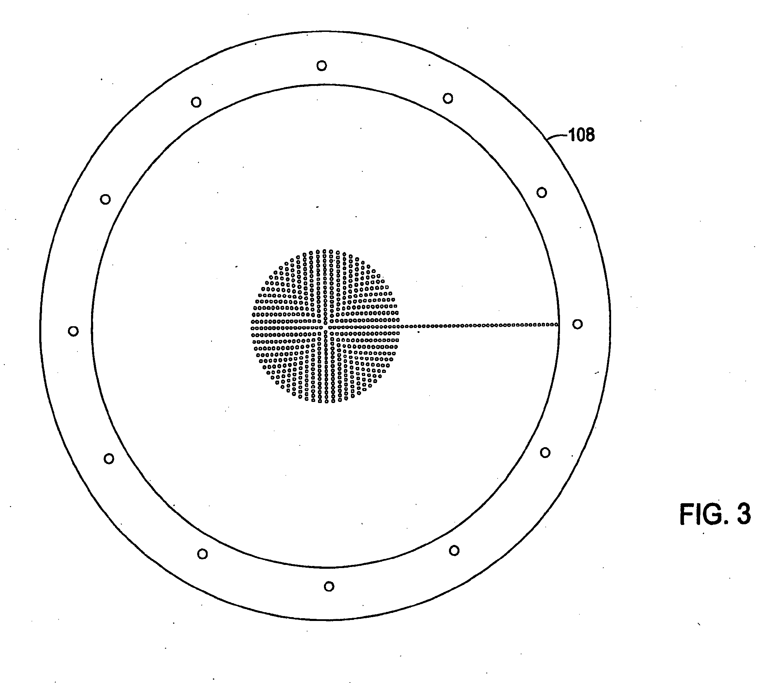

Figure 3 is an illustration of the face plate 108. The face plate 108 is supported by the adapter ring 103. The face plate 108 is connected to the adapter ring 103 by screws and is configured with holes to create a desirable gas inlet distribution within the processing region of the chamber.

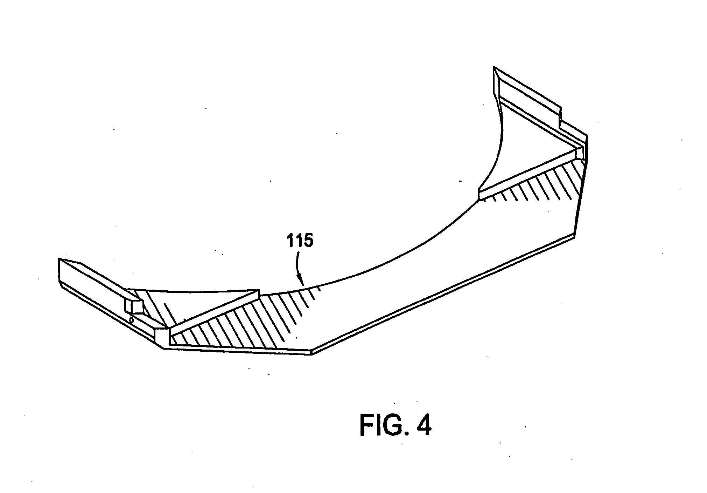

Figure 4 is a three-dimensional view of optional slit valve liner 115. The slit valve liner 115 reduces heat loss through the slit valve opening 114.

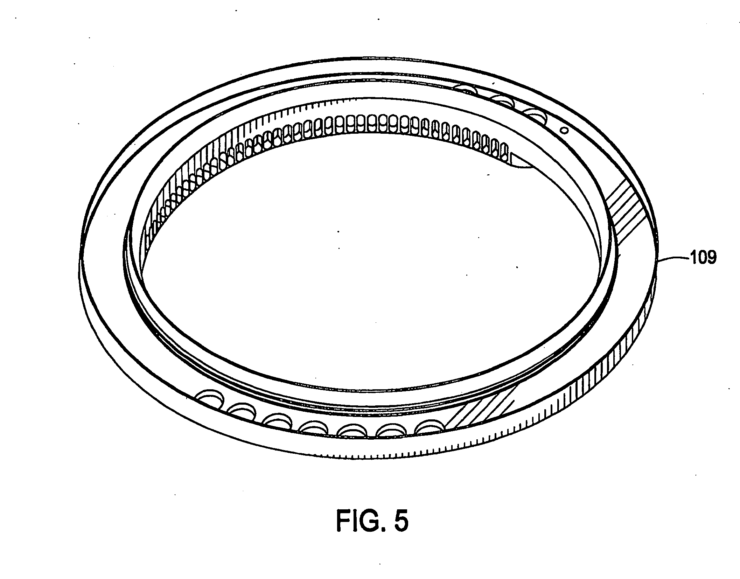

Figure 5 is a three dimensional schematic view of the exhaust plate 109 to control the flow of exhaust from the processing region of the chamber. The schematic illustrates how the plate is configured to modify the exhaust from the chamber to help compensate for heat transfer distortion within the chamber that is created by the slit valve presence.

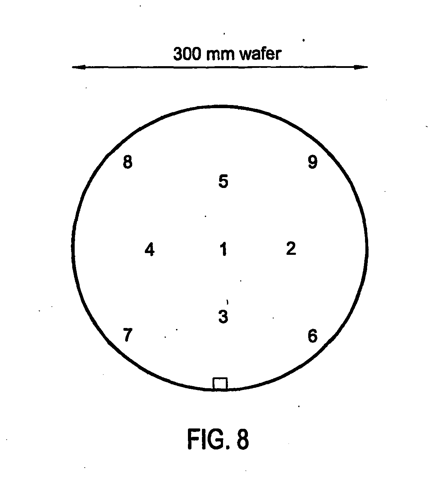

Figure 8 is a three dimensional schematic view of an exhaust plate cover 112 for the exhaust plate 109. The drawing illustrates how the cover is designed with a specific hole pattern to compensate for any exhaust flow distortion within the chamber.

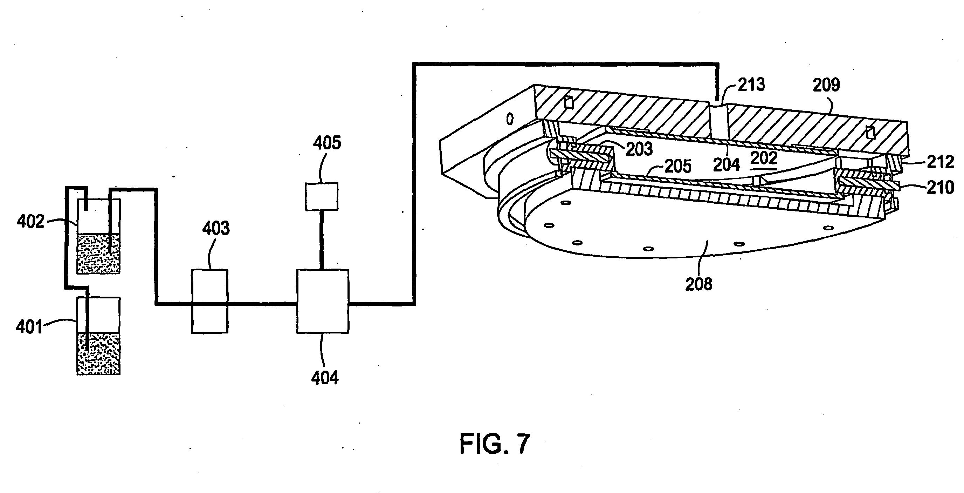

Figure 7 is an expanded view of the lid assembly for a CVD processing chamber such as that of Figure 1 and embodying the present invention. The lid 209 is separated from the rest of the chamber by thermal break elements 212. The thermal break elements 212 are on the upper and lower surface of heater jacket 203. The heater jacket 203 may also be connected to blocker plate 205 and face plate 208. Optionally, parts of the lid or lid components may be heated to a desired temperature.

The lid assembly includes an initial gas inlet 213 to premix the feed gases and parts to form a space 202 defined by the lid 209. the thermal break elements 212, the heater jacket 203, and the blocker plates 204 and 205. The space 202 provides increased residence time for the reactant gases to mix before entering the substrate processing portion of the chamber. Heat that may be applied by the heater 210 to the surfaces that define the space 202 helps prevent the buildup of raw materials, condensates, and by-products along the surfaces of the space. The heated surfaces also preheat the reactant gases to facilitate better heat and mass transfer once the gases exit the face plate 208 and enter the substrate processing portion of the chamber.

Figure 7 is also an illustration of the components of a gas feed system for adding an amino-silicon compound such as BTBAS to a CVD chamber. The BTBAS is stored in a bulk ampoule 401. The BTBAS flows from the bulk ampoule 401 to the process ampoule 402. The BTBAS flows into the liquid flow meter 403. The metered BTBAS flows into a vaporizer 404, such as a plezo-controlled direct liquid injector. Optionally, the BTBAS may be mixed In the vaporizer 404 with a carrier gas such as nitrogen from the gas source 405. Additionally, the cartier gas may be preheated before addition to the vaporizer. The resulting gas is then introduced to the gas inlet 213 in the lid 209 of the CVD chamber. Optionally, the piping connecting the vaporizer 404 and the mixer 113 may be heated.

Figure 8 is a drawing of a substrate showing where the samples were collected across the surface of the substrate.

Within the processing portion of the chamber below the face plate 108, 208, heat distribution is controlled by supplying heat to surfaces such as the face plate, the walls of the chamber, the exhaust plate, and the substrate support. Heat distribution is also controlled by the design of the exhaust plate, the optional insertion of an exhaust plate cover, and the optional insertion of a slit valve liner. Chemical distribution within the processing portion of the chamber is influenced by the design of the face plate and the exhaust plate and the optional exhaust plate cover. Plasma cleaning is also improved when there is a substantial space between the gas inlet in the lid and the face plate and when the face plate is heated.

The second blocker plate 105 and the face plate 108 are heated to prevent chemical deposition on the surface of the blocker plate, preheat the gases in the chamber, and reduce heat loss to the lid. The adaptor ring 103 that attaches the second blocker plate and the face plate to the lid helps thermally isolate the second blocker plate and the face plate from the lid. For example, the lid may be maintained at a temperature of about 30-70 °C, while the second blocker plate and the face plate may be maintained at a temperature of about 100-350 °C. The adapter ring may be designed with uneven thickness to restrict heat loss to the lid, acting like a thermal choke. The thermal separation of the second blocker plate and the face plate from the lid protects the second blocker plate and the face plate from the temperature variations that may be present across the surface of the lid. Thus, the second blocker plate and the face plate are less likely to heat the lid than conventional chambers and can be maintained at a higher temperature than blocker plates and face plates of conventional chambers. The more uniform gas heating provided by the second blocker plate and the face plate results in a more uniform film deposition on a substrate in the chamber. Typically, the second blocker plate and the face plate are heated to a temperature of about 100 to 350°C or greater, such as between about 150 to 300 °C. One observed advantage of a higher temperature second blocker plate and face plate is a higher film deposition rate in the chamber. It is believed that a higher temperature for the second blocker plate and face plate may enhance deposition rates by accelerating the dissociation of the precursors in the chamber. Another advantage of a higher second blocker plate and face plate temperature is a reduction of deposition of CVD reaction byproducts on the second blocker plate and face plate.

The exhaust system also contributes to heat and chemical distribution in the chamber. The pumping plate 109 may be configured with unevenly distributed openings to compensate for heat distribution problems created by the slit valve. The pumping plate may be made of a material that retains heat provided to the processing portion of the chamber by the substrate support assembly to prevent exhaust chemical and by-product deposition on the surface of the plate. The pumping plate features multiple slits placed strategically to also compensate for the silt valve emissivity distortion. The exhaust system helps maintain a pressure of 1.33322 x 10³ N/m² to 46.66 x 10³ N/m² (10 to 350 Torr) in the chamber. The exhaust system controls the pressure using throttle valves and isolation valves. These valves may be heated to a desired temperature to prevent by-product and unused gas and vapor residue formation.

The substrate support assembly 111 has several design mechanisms to enable uniform film distribution. The support surface that contacts the substrate may feature multiple zones for heat transfer to distribute variable heat across the radius of the substrate. For example, the substrate support assembly may include a dual zone ceramic heater that may be maintained at a process temperature of 500-800 °C, for example 600-700 °C. The substrate temperature is typically about 20-30 °C coolers than the measured heater temperature. The support may be rotated to compensate for heat and chemical variability across the interior of the processing portion of the chamber. The support may feature horizontal, vertical, or rotational motion within the chamber to manually or mechanically center the substrate within the chamber.

The surfaces of the processing chamber and its components may be made of anodized aluminum. The anodized aluminum discourages condensation and solid material deposition. The anodized aluminum is better at retaining heat than many substances, so the surface of the material remains warm and thus discourages condensation or product deposition. The material is also less likely to encourage chemical reactions that would result in solid deposition than many conventional chamber surfaces. The lid, walls, spacer pieces, blocker plates, face plate, substrate support assembly, slit valve, slit valve liner, and exhaust assembly may all be coated with or formed of solid anodized aluminum.

Diluent or carrier gas provides another mechanism for tailoring film properties. Nitrogen or helium is used individually or in combination. Hydrogen or argon may also be used. Heavier gas helps distribute heat in the chamber. Lighter gas helps vaporize the precursor liquids before they are added to the chamber. Sufficient dilution of the process gases also helps prevent condensation or solid deposition on the chamber surfaces and in the exhaust system surfaces.

A repeatability test was performed. The film layer thickness for a film deposited in a conventional chamber and a modified chamber that features the additional and/or modified components described above were compared. Significant improvements in wafer uniformity were observed with the modified chamber.
Examples of films that may be deposited in the CVD chambers described herein are provided below. The overall flow rate of gas into the chambers may be 200 to 20,000 sccm and typical processes may have a flow rate of 4,000 sccm. The film composition, specifically the ratio of nitrogen to silicon content, refractive index, wet etch rate, hydrogen content, and stress of any of the films presented herein may be modified by adjusting several parameters. These parameters include the total flow rates, spacing within the chamber, and heating time. The pressure of the system may be adjusted from 1.33322 x 10³ N/m² to 46.66 x 10³ N/m² (10 to 350 Torr) and the concentration ratio of NH₃ to BTBAS may be adjusted from 0 to 100.

### Silicon Nitride Films

Silicon nitride films may be chemical vapor deposited in the chambers described herein by reaction of a silicon precursor with a nitrogen precursor. Silicon precursors that may be used include dichlorosilane (DCS), hexachlorodisilane (HCD), bis(tertiary-butylamino)silane (BTBAS), silane (SiH₄), disilane (Si₂H₆), and many others. Nitrogen precursors that may be used include ammonia (NH₃), hydrazine (N₂H₄), and others. For example, SiH₄ and NH₃ chemistry may be used.

in the CVD processing chamber, SiH₄ dissociates into SiH₃, SiH₂ primarily, and possibly SIH. NH₃ dissociates into NH₂. NH, and H₂. These intermediates react to form SiH₂NH₂ or SiH3NH₂ or similar amino-silane precursors that diffuse through the gas boundary layer and react at or very near the substrate surface to form a silicon nitride film. It is believed that the warmer chamber surfaces- provide heat to the chamber that increases NH₂ reactivity. The increased volume of the space between the gas inlet in the lid of the chamber and the second blocker plate increases the feed gas residence time and increases the probability of forming desired amino-silane precursors. The increased amount of the formed precursors reduces the probability of pattern micro-loading, i.e. the depletion of the precursors in densely patterned areas of the substrate.
It was also found that increasing the NH₃ flow rate relative to the flow rate of the other precursors enhanced the deposition of films. For example, conventional systems may operate with flow rates of NH₃ to SiH₄ in a ratio of 60 to 1. Test results indicate a conventional ratio of 60 to 1 to 1000 to 1 provides a uniform film when spacing between the lid and the second blocker plate is increased. It was further found that using a spacing of 19.05 mm - 21.59 mm (750-850 mils) between the face plate the substrate enhanced the film uniformity compared to films deposited at 16.51 mm (650 mils).

### Carbon Doped Silicon Nitride Films

In one embodiment, BTBAS may be used as a silicon containing precursor for deposition of carbon doped silicon nitride films in the chambers describe herein. The following is one mechanism that it may follow to produce a carbon doped silicon nitride film with t-butylamine by-products. The BTBAS may then react with the t-butylamine to form isobutylene.

3C₈H₂₂N₂Si + NH₃ => Si₃N₄⁺ NH₂C₄H₉

Four example conditions are elucidated. Pressure, temperature, spacing, flow rate, and other conditions are shown in Table 1. Column 1 shows a set of operating conditions at lower BTBAS concentration than the other examples. Column 2 shows operation at low temperature and wet etch ratio. Column 5 shows the lowest wet etch ratio and temperature and column 6 shows operating parameters for the combination of highest deposition rate and the lowest pattern loading effect of the four examples. In the examples, the wafer heater temperature was 675 to 700°C and the pressure of the chamber was 6.67 kPa to 36.66 kPa (50 to 275 Torr).

The BTBAS reaction to form the carbon doped silicon nitride film may be reaction rate limited, not mass transfer limited. Films formed on a patterned substrate may uniformly coat the exposed surfaces of the patterned substrate. BTBAS may have less pattern loading effect (PLE) than the conventional silicon precursors, for example SiH₄. Table 1- shows the sidewall PLE for BTBAS and NH₃ chemistry is less than 5%, compared to more than 15% for a SiH₄ and NH₃ process in the same chamber. It **is** believed that the pattern loading effect experienced with some silicon containing precursors is due to the mass transfer limitations of the reactions between those precursors, for example SiH₄ with NH₃.

**Table 1. Operating Conditions for Testing BTBAS Performance**

| recipe name | #1 | #2 | #5 | #6 |
|---|---|---|---|---|
| wafer temperature (°C) | -670 | ~655 | ~660 | ~675 |
| heater temp (°C) | 675 | 675 | 675 | 700 |
| kPa pressure (Torr) | 36.66 (275) | 21.33 (21.33) | 10.67 (80) | 6.67 (50) |
| NH3 (sccm) | 80 | 80 | 80 | 80 |
| BTBAS (grams/min) | 0.61 | 1.2 | 1.2 | 1.2 |
| BTBAS (sccm) | 78 | 154 | 154 | 154 |
| N2-carrier top (slm) | 4 | 4 | 4 | 4 |
| N2-dep-top (slm) | 10 | 10 | 6 | 6 |
| N2-bottom (slm) | 10 | 10 | 10 | 10 |
| mm spacing (mills) | 17.78 (700) | 17.78 (700) | 17.78 (700) | 17.78 (700) |
| deposition rate (A/min) | 230 | 250 | 170 | 250 |
| BTBAS consumption (grams/100A film) | 0.27 | 0.48 | 0.71 | 0.48 |
| Wet etch rate ratio (%) | 25 | 16 | 11 | 12 |
| stress (dynes/sq.cm) - 500A film | 1.54 | 1.54 | 1.51 | 1.67 |
| R1 | 1.865 | 1.885 | 1.935 | 1.985 |
| Thickness non-uniformity 1 sigma (%) | <1.5 | <1.5 | <1.5 | <1.5 |
| PLE on 90nm SRAM chip by TEM | | | | |
| Sidewall PLE (%) | 7 | 9 | 3 | 3 |
| Bottom PLE (%) | 7 | 3 | 3 | 3 |

Using BTBAS as a reactant gas also allows carbon content tuning. That is, by selecting operating parameters such as pressure and nitrogen containing precursor gas concentration, the carbon content of the resulting film may be modified to produce a film with the desired carbon content and more uniform carbon concentration across the diameter of a substrate. BTBAS may be added to the system at a rate of 0.05 to 2.0 g/min and typical systems may use 0.3-0.6 g/min. Table 2 provides flow rates, concentration, and resulting film properties for three configurations.

The C 5-6 % and C 12-13 % configurations based on designed experiment data analysis are predicted values. The C 10.5 % value is an experimental result. VR indicates the voltage ratio of the outer to inner zones of the dual zone ceramic heater used as the heat source susceptor for the silicon substrate. RI indicates the refractive index. WERR is the wet etch rate ratio of the nitride film relative to that of a thermally grown silicon oxide film used as reference.

**Table 2. Three BTBAS configurations and the resulting film properties.**

| | | C 5-6% (predicted) | C 10.5% (tested) | C 12-13% (predicted) |
|---|---|---|---|---|
| dep rate | (Ang/min) | 315.4 | 266.9 | 399.4 |
| dep time | (sec) | 136 | 160 | 106 |
| target thickness | (Ang) | 700 | 700 | 700 |
| monitor film thickness | (Ang) | 714.97 | 711.715 | 705.545 |
| monitor N/U 1-sigma | (%) | 2.371 | 1.437 | 1.492 |
| VR | | 0.98 | 0.98 | 0.98 |
| RI | | 1.821 | 1.82 | 1.817 |
| BTBAS consumption | (grams/500Ang film) | 0.897 | 0.571 | 0.782 |
| stress | (Gpa) | - | 1.2 | - |
| WERR | | - | 0.5 | - |
| heater temp | (C) | 675 | 675 | 675 |
| chamber pressure | (kPa) | 21.66 | 36.66 | 21.33 |
| | (Torr) | (162.5) | (275) | (160) |
| BTBAS flow | (grams/min) | 0.566 | 0.305 | 0.625 |
| | (sccm) | 74.2 | 40 | 81.9 |
| NH3 flow | (sccm) | 300 | 40 | 40 |
| N2 carrier flow | (slm) | 2 | 2 | 2 |
| N2 flow | (slm) | 1.7 | 3 | 2 |
| total top gas flow | (slm) | ~4 | -5 | ~4 |
| N2 bottom flow | (slm) | 3 | 3 | 3 |
| spacing | (mm) | 17.78 | 17.78 | 17.78 |
| | (mils) | (700) | (700) | (700) |

Table 3 gives an element by element composition of samples taken from various points across a substrate for different process conditions. The element composition of the samples was measured by nuclear reaction analysis and Rutherford backscattering spectroscopy.

**Table 3. Atomic Composition Based on Location Across Substrate Surface**

| | 300mm BTBAS film composition by NRA/RBS | | | | |
|---|---|---|---|---|---|
| Location | SI | N | H | C | O |
| # coordinates | (%) | (%) | (%) | (%) | (%) |
| 1 (0mm.0 deg) | 31.7% | 31.7% | 22.2% | 12.7% | 1.6% |
| 2 (7.5mm. 0 deg) | 31.7% | 31.7% | 22.2% | 12.7% | 1.6% |
| 3 (75mm. 90 deg) | 31.7% | 31.7% | 22.2% | 12.7% | 1.6% |
| 4 (75mm. 180 deg) | 30.8% | 30.8% | 21.5% | 15.4% | 1.5% |
| 5 (75mm. 270 deg) | 31.7% | 31.7% | 22.2% | 12.7% | 1.6% |
| 6 (145mm. 45 deg) | 31.7% | 31.7% | 22.2% | 12.7% | 1.6% |
| 7 (145mm. 135 deg) | 31.7% | 31.7% | 22.2% | 12.7% | 1.6% |
| 8 (145mm. 225 deg) | 31.7% | 31.7% | 22.2% | 12.7% | 1.6% |
| 9 (145mm. 315 deg) | 31.7% | 31.7% | 22.2% | 12.7% | 1.6% |
| In-wafer average = | 31.6% | 31.6% | 22.1% | 13.0% | 1.6% |
| In-wafer std dev = | 0.326% | 0.326% | 0.228% | 0.895% | 0.016% |

Table 3 illustrates that the variation in carbon content across the surface of the substrate was 0.895%. It was found that carbon doped silicon nitride films having from 2 to 18 atomic percentage carbon were deposited at enhanced rates in the chambers described herein.

Using BTBAS as the silicon containing precursor offers several resulting film property advantages. Increasing the carbon content of the film can improve the dopant retention and junction profile, resulting in improved performance in the positive channel metal oxide semiconductor (PMOS) part of the device. The process parameters may also be tailored when combined with the use of BTBAS to facilitate improved stress profile. Enhanced film stress improves the device performance for the negative channel metal oxide semiconductor (NMOS) part to of the device. Film stress properties are influenced by tailoring the chamber pressure, total feed gas flow, the NH₃ and BTBAS feed gas ratio, and the volume fraction of BTBAS.

Additional experimental results indicate that at 675°C the standard deviation for film non-uniformity was less than 1.5 percent. The standard deviation of the composition of the film non-uniformity over a temperature range of 645 to 675 °C was less than 1.5 percent as well. The particle contamination was less than 30 particles at greater than or equal to 0.12 µm.
The wet etch ratio is lower when low concentration NH₃ and low pressure are selected. The pressure range tested was 6.67 kPa to 36.66 kPa (50 to 275 Torr). The wet etch ratio was measured as less than 0.3. The wet etch ratio of the film was calculated by comparing the film etch to a thermal oxide with 100:1 HF. RMS roughness at 400 A was measured to be 0.25 nm.

The film deposition rate over 625 to 675 °C was 125 to 425 A. The deposition rate was higher when higher concentration of BTBAS, lower NH₃ concentration, and higher pressure and temperature were selected.

The hydrogen concentration of the film was less than 15 atomic percent. It is estimated that the hydrogen is mostly bonded within the film as N-H. The carbon content of the film was 2 to 18 atomic percent

The observed stress was 1 E9 to 2 E10 dynes/cm² (0.1 to 2 GPa) for an enhanced NMOS I-drive. The stress was higher with high concentrations of NH₃, low concentration of BTBAS, and low pressure.

The measured refractive index over the same temperature range was 1.75 to 1.95. The refractive index was higher when the system was operated at lower pressure and lower BTBAS concentration.

Also, the observed or estimated carbon concentration ranged from 2 to 18 percent. It was highest when the NH₃ concentration was low and the concentration of BTBAS was high.

Table 1 results may be compared to conventional and similar systems. The wet etch rate ratio test results in Table 1 may be compared to silicon nitride films deposited in conventional furnace systems which have a one minute dip in 100 :1 HF. The stress test results of Table 3 are similar to other test results for similar operating conditions that have results of 0.1 to 2.0 GPa.

Typically, nitrogen is used as both the carrier gas from the gas source for BTBAS as well as the diluent gas for the thermal CVD reaction. Using hydrogen as the diluent gas results in increasing the deposition rate of the BTBAS and NH₃ thermal CVD reaction by up to 30%. Using germane doped in hydrogen as the diluent gas may also increase the deposition rate even further.

While a precursor like BTBAS acts as a source of both silicon and carbon, it is possible to combine a silicon precursor such as silane, disilane, hexachlorodisilane, and dichlorosilane with a carbon precursor such as ethylene, butylenes, and other alkenes or other carbon sources and react the two precursors with NH₃ in a single wafer thermal CVD chamber to form a carbon doped silicon nitride film.

### Carbon Doped Silicon Oxide Films

BTBAS also offers some process chemistry flexibility. For BTBAS based oxide processes, NH₃ can be substituted by an oxidizer such as N₂O. Thermal CVD in the hardware described in this invention can be used to deposit oxide films.

While a precursor like BTBAS acts as a source of both silicon and carbon, it is possible to combine a silicon precursor such as silane, disilane, hexachlorodisilane, and dichlorosilane with a carbon precursor such as ethylene, butylenes, and other alkenes or other carbon sources and react the two precursors with N₂O in a single wafer thermal CVD chamber to form a carbon doped silicon oxide film.

### Carbon Doped Silicon Oxide Nitride Films

In general, carbon doped or carbon containing silicon oxide nitride films can be deposited using a combination of silicon containing precursors, carbon containing precursors, oxygen containing precursors, and nitrogen containing precursors. These films have potential use in future generation devices to enable dielectric constant control in addition to carbon content control. Such low-k thermally deposited CVD films can be of potential benefit in devices.

To manufacture a carbon doped or carbon containing silicon oxide-nitride film, BTBAS may be used with NH₃ and an oxidizer such as N₂O. Thermal CVD in the hardware described in this invention can be used to deposit oxide nitride films.

While a precursor like BTBAS acts as a source of both silicon and carbon, it is possible to combine a silicon precursor such as silane, disilane, hexachlorodisilane, and dichlorosilane with a carbon precursor such as ethylene, butylenes, and other alkenes or other carbon sources and react the two precursors with both NH₃ and N₂O in a single wafer thermal CVD chamber to form a carbon doped silicon oxide nitride film.

Many commonly used low-k precursors such as trimethylsilane and tetramethyl silane contain silicon, oxygen, and carbon. These precursors can be reacted with a nitrogen source such as NH₃ to form carbon doped silicon oxide nitride films in a single wafer thermal CVD chamber.

While the foregoing is directed to embodiments of the present invention, other and further embodiments of the invention may be devised without departing from the basic scope thereof, and the scope thereof is determined by the claims that follow.

## Claims

1. A CVD apparatus for low temperature deposition of a film on a semiconductor substrate, comprising:
a chamber body (106) and a chamber lid (209) defining a processing region;
a substrate support (111) disposed in the processing region;
a gas delivery system mounted on the chamber lid, the gas delivery system including blocker and face plates (204, 205, 208) that define a gas mixing region (202), and a heating element;
**characterised in that** the gas delivery system includes two spaced blocker plates (204, 205) and an adapter ring (203) defining the gas mixing region (202), the heating element (210) being positioned to heat the adapter ring, a face plate (208) fastened to the adapter ring and thermal break elements (212) located between the adapter ring and the chamber lid.

2. An apparatus as claimed in claim 1, **characterised in that** one (204) of the blocker plates is fastened to the chamber lid and the other (205) blocker plate is fastened to the adapter ring.

3. An apparatus as claimed in claim 1, **characterised in that** the heating element (210) contacts the adapter ring (203).

4. An apparatus as claimed in claim 1, **characterised in that** the face plate (204, 205) is adapted to be heated to 150-250°C.

5. An apparatus as claimed in claim 1, **characterised in that** the substrate support (111) is adapted to be heated to 550-800°C.

6. An apparatus as claimed in claim 1, **characterised in that** the lid (209) is adapted to be heated to 60-80°C.

7. An apparatus as claimed in claim 1, **characterised in that** a slit valve liner (115) is positioned in a slit valve channel (114) in the chamber body (106).

8. An apparatus as claimed in claim 1, **characterised in that** an exhaust pumping plate (109) surrounds the substrate support (111) and a cover plate (112) is located on the exhaust pumping plate (109), the cover plate having adequately distributed holes.

9. An apparatus as claimed in claim 1, **characterised in that** an exhaust valve assembly has components adapted to be heated to 30-200°C.

10. An apparatus as claimed in claim 1, **characterised in that** a vaporizer (404) is in fluid communication with the mixing region (202).

11. An apparatus as claimed in claim 10, **characterised in that** the vaporizer is in fluid communication with a.source of bis(tertiary-butylamino)silane.

12. An apparatus as claimed in claim 1, **characterised in that** the gas delivery system is above the substrate support (111).

13. An apparatus as claimed in claim 12, **characterised in that** the substrate support (111) is below the faceplate and wherein the faceplate is below the blocker plates.

14. An apparatus as claimed in claim 1, **characterised in that** the two blocker plates comprise a first blocker plate (204) fastened to the lid (209) and a second blocker plate (205) fastened to the adapter ring (203).

15. An apparatus as claimed in claim 14, **characterised in that** an exhaust pumping plate (109) surrounds the substrate support (111) and a cover plate is located on the exhaust pumping plate, the cover plate having adequately distributed holes.

16. An apparatus as claimed in claim 14, **characterised in that** the exhaust valve assembly has components are provided adapted to be heated to 30-200°C.

17. An apparatus as claimed in claim 14, **characterised in that** a slit valve liner (115) is positioned in a slit valve opening (114) in the chamber body (205).

18. An apparatus as claimed in claim 14, **characterised in that** a vaporizer (404) is in fluid communication with the mixing region.

19. An apparatus as claimed in claim 18, **characterised in that** the vaporizer (404) is in fluid communication with a source of bis(tertiary-butylamino)silane.

20. An apparatus as claimed in claim 18, **characterised in that** the vaporizer (404) is in fluid communication with a carrier gas system.

21. An apparatus as claimed in claim 14, **characterised in that** the gas delivery system is above the substrate support (111).

22. An apparatus as claimed in claim 21, **characterised in that** the substrate support (111) is below the faceplate (108) and wherein the faceplate is below the blocker plates.

## Patentansprüche

1. CVD-Vorrichtung zur Tieftemperatur-Deposition eines Films auf einem Halbleiter-Substrat, umfassend:
einen Kammerkörper (106) und einen Kammerdeckel (209), die einen Prozessbereich definieren,
einen im Prozessbereich angeordneten Substrathalter (111), ein auf dem Kammerdeckel angebrachtes Gaszuführungssystem, wobei das Gaszuführungssystem Hemm- und Stirnplatten (204, 205, 208) umfasst, die einen Gasmischungsbereich (202) definieren, und ein Heizelement,
**dadurch gekennzeichnet, dass** das Gaszuführungssystem zwei beabstandete Hemmplatten (204, 205) und einen Adapterring (203) umfasst, die den Gasmischungsbereich (202) definieren, wobei das Heizelement (210) positioniert ist, um den Adapterrring zu heizen, eine Stirnplatte (208) an dem Adapterring befestigt ist und sich thermische Trennelemente (212) zwischen dem Adapterring und dem Kammerdeckel befinden.

2. Vorrichtung nach Anspruch 1,
**dadurch gekennzeichnet, dass** eine (204) der Hemmplatten an dem Kammerdeckel befestigt ist und die andere (205) Hemmplatte an dem Adapterring befestigt ist.

3. Vorrichtung nach Anspruch 1,
**dadurch gekennzeichnet, dass** das Heizelement (210) in Kontakt mit dem Adapterring (203) steht.

4. Vorrichtung nach Anspruch 1,
**dadurch gekennzeichnet, dass** die Stirnplatte (204, 205) dazu geeignet ist, auf 150-250°C geheizt zu werden.

5. Vorrichtung nach Anspruch 1,
**dadurch gekennzeichnet, dass** der Substrathalter (111) dazu geeignet ist, auf 550-800°C geheizt zu werden.

6. Vorrichtung nach Anspruch 1,
**dadurch gekennzeichnet, dass** der Deckel (209) dazu geeignet ist, auf 60-80°C geheizt zu werden.

7. Vorrichtung nach Anspruch 1,
**dadurch gekennzeichnet, dass** eine Schlitzventil-Auskleidung (115) in einem Schlitzventil-Kanal (114) in dem Kammerkörper (106) positioniert ist.

8. Vorrichtung nach Anspruch 1,
**dadurch gekennzeichnet, dass** eine Auslass-Pump-Platte (109) den Substrathalter (111) umgibt und sich eine Deckplatte (112) auf der Auslass-Pump-Platte (109) befindet, wobei die Deckplatte angemessen verteilte Löcher aufweist.

9. Vorrichtung nach Anspruch 1,
**dadurch gekennzeichnet, dass** eine Auslassventilanordnung Komponenten aufweist, die dazu geeignet ist, auf 30-200°C geheizt zu werden.

10. Vorrichtung nach Anspruch 1,
**dadurch gekennzeichnet, dass** ein Verdampfer (404) in Strömungsverbindung mit dem Mischbereich (202) steht.

11. Vorrichtung nach Anspruch 10,
**dadurch gekennzeichnet, dass** der Verdampfer in Strömungsverbindung mit einer Bis(tertiärbutylamino)silan-Quelle steht.

12. Vorrichtung nach Anspruch 1,
**dadurch gekennzeichnet, dass** das Gaszuführungssystem oberhalb des Substrathalters (111) ist.

13. Vorrichtung nach Anspruch 12,
**dadurch gekennzeichnet, dass** der Substrathalter (111) unterhalb der Stirnplatte ist und wobei die Stirnplatte unterhalb der Hemmplatten ist.

14. Vorrichtung nach Anspruch 1,
**dadurch gekennzeichnet, dass** die zwei Hemmplatten eine erste, an dem Deckel (209) befestigte Hemmplatte (204) und eine zweite, an dem Adapterring (203) befestigte Hemmplatte (205) umfassen.

15. Vorrichtung nach Anspruch 14,
**dadurch gekennzeichnet, dass** eine Auslass-Pump-Platte (109) den Substrathalter (111) umgibt und sich eine Deckplatte auf der Auslass-Pump-Platte befindet, wobei die Deckplatte angemessen verteilte Löcher aufweist.

16. Vorrichtung nach Anspruch 14,
**dadurch gekennzeichnet, dass** eine Auslassventilanordnung Komponenten aufweist, die dazu geeignet ist, auf 30-200°C geheizt zu werden.

17. Vorrichtung nach Anspruch 14,
**dadurch gekennzeichnet, dass** eine Schlitzventil-Auskleidung (115) in einer Schlitzventil-Öffnung (114) in dem Kammerkörper (205) positioniert ist.

18. Vorrichtung nach Anspruch 14,
**dadurch gekennzeichnet, dass** ein Verdampfer (404) in Strömungsverbindung mit dem Mischbereich steht.

19. Vorrichtung nach Anspruch 18,
**dadurch gekennzeichnet, dass** der Verdampfer (404) in Strömungsverbindung mit einer Bis(tertiärbutylamino)silan-Quelle steht.

20. Vorrichtung nach Anspruch 18,
**dadurch gekennzeichnet, dass** der Verdampfer (404) in Strömungsverbindung mit einem Trägergassystem steht.

21. Vorrichtung nach Anspruch 14,
**dadurch gekennzeichnet, dass** das Gaszuführungssystem oberhalb des Substrathalters (111) ist.

22. Vorrichtung nach Anspruch 21,
**dadurch gekennzeichnet, dass** der Substrathalter (111) unterhalb der Stirnplatte (108) ist und wobei die Stirnplatte unterhalb der Hemmplatten ist.

## Revendications

1. Appareil de dépôt chimique en phase vapeur (CVD) pour un dépôt à basse température d'un film sur un substrat semiconducteur, comprenant :
un corps de chambre (106) et un couvercle de chambre (209) définissant une région de traitement,
un support de substrat (111) disposé dans la région de traitement,
un système de délivrance de gaz monté sur le couvercle de chambre, le système de délivrance de gaz comprenant des plaques de blocage et de face (204, 205, 208) qui définissent une région de mélange de gaz (202), et un élément chauffant,
**caractérisé en ce que** le système de délivrance de gaz comprend deux plaques de blocage écartées (204, 205) et une bague d'adaptation (203) définissant la région de mélange de gaz (202), l'élément chauffant (210) étant positionné pour chauffer la bague d'adaptation, une plaque de face (208) étant fixée à la bague d'adaptation et des éléments de barrière thermique (212) étant situés entre la bague d'adaptation et le couvercle de chambre.

2. Appareil selon la revendication 1, **caractérisé en ce que** l'une (204) des plaques de blocage est fixée au couvercle de chambre et l'autre (205) plaque de blocage est fixée à la bague d'adaptation.

3. Appareil selon la revendication 1, **caractérisé en ce que** l'élément chauffant (210) est en contact avec la bague d'adaptation (203).

4. Appareil selon la revendication 1, **caractérisé en ce que** la plaque de face (204, 205) est conçue pour être chauffée à 150-250°C.

5. Appareil selon la revendication 1, **caractérisé en ce que** le support de substrat (111) est conçu pour être chauffé à 550-800°C.

6. Appareil selon la revendication 1, **caractérisé en ce que** le couvercle (209) est conçu pour être chauffé à 60-80°C.

7. Appareil selon la revendication 1, **caractérisé en ce qu'**un revêtement de vanne à fentes (115) est positionné dans un canal de vanne à fentes (114) dans le corps de chambre (106).

8. Appareil selon la revendication 1, **caractérisé en ce qu'**une plaque de pompage d'échappement (109) entoure le support de substrat (111) et une plaque de capot (112) est située sur la plaque de pompage d'échappement (109), la plaque de capot ayant des trous répartis de manière adéquate.

9. Appareil selon la revendication 1, **caractérisé en ce qu'**un ensemble de vanne d'échappement a des composants conçus pour être chauffés à 30-200°C.

10. Appareil selon la revendication 1, **caractérisé en ce qu'**un vaporisateur (404) est en communication de fluide avec la région de mélange (202).

11. Appareil selon la revendication 10, **caractérisé en ce que** le vaporisateur est en communication de fluide avec une source de bis(butylamino tertiaire)silane.

12. Appareil selon la revendication 1, **caractérisé en ce que** le système de délivrance de gaz est au-dessus du support de substrat (111).

13. Appareil selon la revendication 12, **caractérisé en ce que** le support de substrat (111) est en dessous de la plaque de face et dans lequel la plaque de face est en dessous des plaques de blocage.

14. Appareil selon la revendication 1, **caractérisé en ce que** les deux plaques de blocage comprennent une première plaque de blocage (204) fixée au couvercle (209) et une deuxième plaque de blocage (205) fixée à la bague d'adaptation (203).

15. Appareil selon la revendication 14, **caractérisé en ce qu'**une plaque de pompage d'échappement (109) entoure le support de substrat (111) et une plaque de capot est située sur la plaque de pompage d'échappement, la plaque de capot ayant des trous répartis de manière adéquate.

16. Appareil selon la revendication 14, **caractérisé en ce que** l'ensemble de vanne d'échappement a des composants conçus pour être chauffés à 30-200°C.

17. Appareil selon la revendication 14, **caractérisé en ce qu'**un revêtement de vanne à fentes est positionné dans une ouverture de vanne à fentes (114) dans le corps de chambre (205) .

18. Appareil selon la revendication 14, **caractérisé en ce qu'**un vaporisateur (404) est en communication de fluide avec la région de mélange.

19. Appareil selon la revendication 18, **caractérisé en ce que** le vaporisateur (404) est en communication de fluide avec une source de bis(butylamino tertiaire)silane.

20. Appareil selon la revendication 18, **caractérisé en ce que** le vaporisateur (404) est en communication de fluide avec un système de gaz porteur.

21. Appareil selon la revendication 14, **caractérisé en ce que** le système de délivrance de gaz est au-dessus du support de substrat (111).

22. Appareil selon la revendication 21, **caractérisé en ce que** le support de substrat (111) est au-dessous de la plaque de face (108) et dans lequel la plaque de face est au-dessous des plaques de blocage.
